# EUROPEAN PATENT SPECIFICATION

(11) **EP 0 472 420 B1**
(45) Date of publication and mention of the grant of the patent: **22.11.1995**
(21) Application number: 91307690.7
(22) Date of filing: 21.08.1991
(51) Int. Cl.: H01R 9/07, G06K 7/06, H01R 23/72

(54) **IC card connection structure**
Anschlussaufbau für Karten mit integriertem Schaltkreis
Structure de connexion pour cartes à circuit intégré

(30) Priority: 22.08.1990 JP 218996/90
(43) Date of publication of application: 26.02.1992
(73) Proprietor: Oki Electric Industry Co., Ltd., Tokyo (JP)
(72) Inventor: Narita, Kiyokazu, 7-12 Toranomon 1-chome, Minato-ku (JP); Hirata, Hiroharu, 7-12 Toranomon 1-chome, Minato-ku (JP)
(74) Representative: Read, Matthew Charles

(56) References cited:
- EP-A- 0 106 990
- EP-A- 0 357 827
- PATENT ABSTRACTS OF JAPAN vol. 13, no. 547 (P-971)7 December 1989

## Description

The present invention relates to an IC card connection structure for connecting an IC card reader or writer to an IC card, including contact points arranged to contact the electrical terminals of an IC card.

There are two types of IC cards as an international standard (standard stipulated in 7816-2 of International Organization for Standardization), i.e. an upper position type and a lower position type depending on the difference of the arrangement of the IC contact positions.

An IC card connection structure for connecting an IC card reader or writer to an IC card, including contact points arranged to contact the electrical terminals of an IC card is disclosed in JP-A-01-226090. However, this document discloses the structure as having a sliding contact which is slidable relative to an upper position or a lower position of the IC contact positions on the IC card so as to contact the contact points in the upper position or the lower position. However, according to this structure, an operator usually judges that the IC contact position of the IC card is the upper position type or the lower position type and thereafter slides the contact. Accordingly, there was a problem that the control circuit of the IC card reader/writer cannot supply data to or receive the data from the IC card when the sliding contact is slided to an erroneous position. There was another problem that an IC chip in the IC card is broken when the operator interrupts to slide the sliding contact since the voltage for IC card is supplied to the sliding contact.

It is an object of the present invention to solve the problem set forth above and to provide the IC card connection structure having a contact capable of contacting the contact points of the IC card at the fixed state, thereby obviating the occurrence of sliding of the contact in the wrong or intermediate position so as to assure the supply and reception of the data between the IC card and the IC card reader/writer and eliminate the breakage of the IC chip.

A connection strucure according to the present invention characterised in that the contact points include a first group of contact points include a first group of contact points disposed for contacting IC card terminals configured in a first manner on the card and a second group of contact points disposed for contacting IC card terminals configured in a second, different manner on the card. In the arrangement of the IC card connection structure, it is possible to mount the contact pins on the contact for enabling the contact with the contact points of the IC card in common with the two types of contact positions. As a result, it is possible to obviate the occurrence of sliding of the contact in the wrong or intermediate position so as to assure the supply and reception of the data between the IC card and the IC card reader/writer and eliminate the breakage of the IC chip.
Fig. 1 is a perspective view of an IC card connection structure according to a preferred embodiment of the present invention;
Fig. 2 is a plan view showing contact points of an IC card in Fig. 1;
Fig. 3 is a plan view showing a flexible cable employed in the preferred embodiment of the present invention;
Fig. 4 is a plan view showing a flexible cable employed in a modification of the present invention;
Fig. 5 is a perspective view showing a typical IC card transaction processing apparatus;
Fig. 6 is an enlarged perspective view of an IC card insertion portion in Fig. 5;
Fig. 7 is a plan view showing contact points of another IC card; and
Fig. 8 is a plan view of a flexible cable employed in the use of the IC card in Fig. 7.

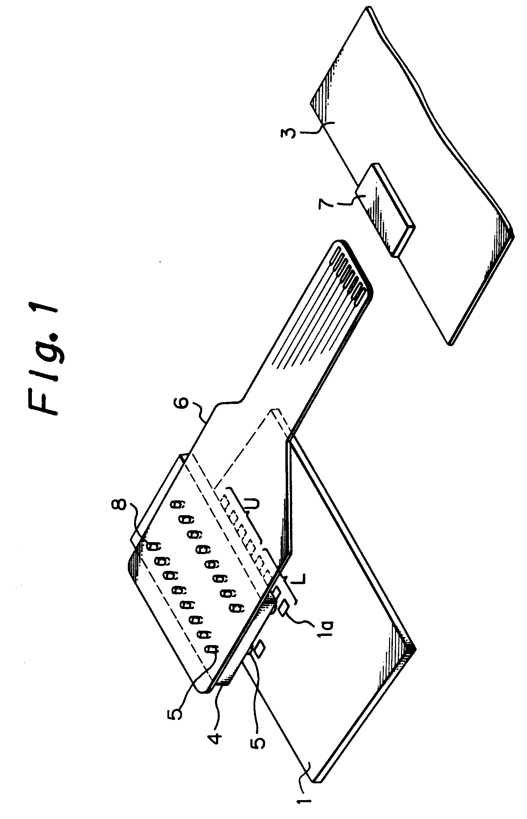

The IC card connection structure will be described with reference to Figs.1 to 8.

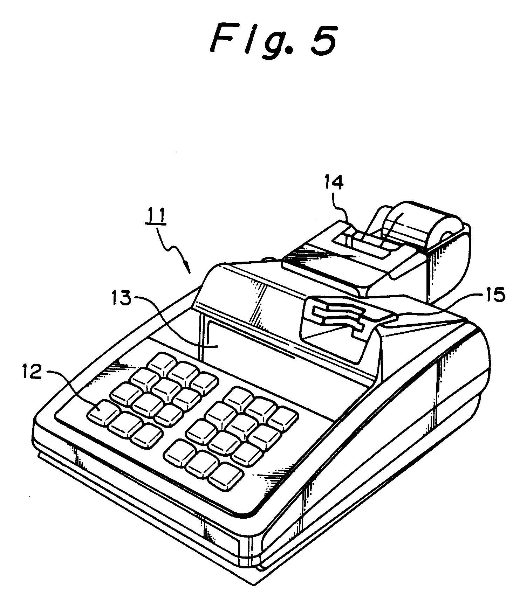

Fig. 5 is a perspective view of a typical IC card transaction processing apparatus 11. In Fig. 5, the IC card transaction processing apparatus 11 comprises a key board 12 for receiving data, a display 13 for displaying the operation guide of the apparatus 11 and the input data, a printing portion 14 for printing a transaction detail on a roll sheet and an IC card insertion portion 15.

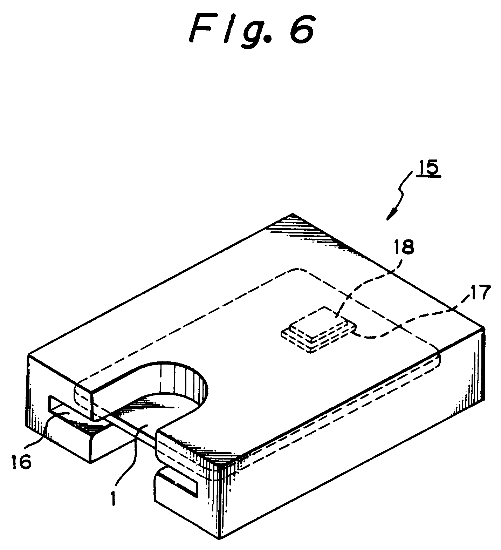

Fig. 6 is an enlarged perspective view showing the IC card insertion portion 15 in Fig. 5.

The IC card insertion portion 15 comprises an IC card insertion slit 16 in which an IC card having contact points 17 for contacting the IC contact is inserted. 18 is a contact for contacting the contact points 17 of the IC card, thereby suppying data to or receiving data from the IC card reader/writer, not shown.

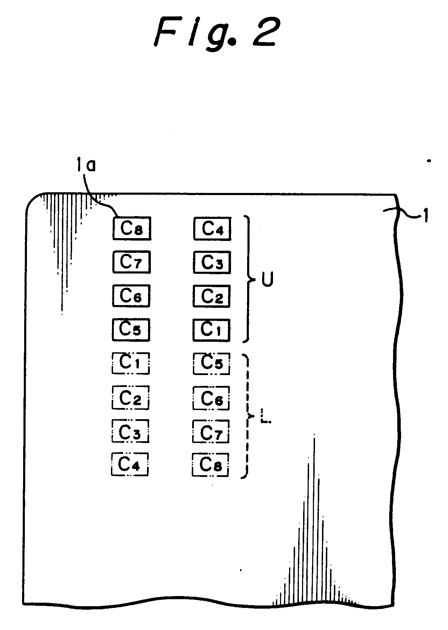

Fig. 2 is a plan view showing an arrangement of the contact points 1a of the IC card 1, wherein the contact points 1a are located at a position U, if the IC contact position is the upper position type, while the contacts 1a are located at a position L, if the IC contact position is the lower position type. Like contact points 1a in both the upper and lower position types are denoted by the same numerals C1 to C8. C1 are circuit voltage terminals, C2 are reset signal terminals, C3 are program supply voltage terminals, C4 are spare terminals, C5 are zero voltage terminals, C6 are program supply voltage terminals, C7 are data input/output terminals and C8 are spare terminals. The contact points 1a denoted by the same numerals, e.g. the contact point C1 in the upper position U and the contact point C1 in the lower position L carry the same signal. This is defined in the international standard (stipulated in 7816-2 of the ISO).

Fig. 1 is a perspective view showing the IC card connection structure according to the present invention.

Denoted at 1 is the IC card, 3 is a control circuit of the IC card reader/writer and 4 is a contact. The contact 4 has contact pins 5 at upper and lower surfaces thereof for contacting all the contact points 1a arranged in both the upper contact position U and the lower contact position L. 6 is a flexible cable for connecting the contact 4 to the control circuit 3 and has soldered portions 8 which the contact pins 5 are inserted into and connected to. 7 is a connector mounted on the control circuit 3 for inserting the flexible cable 6 thereinto.

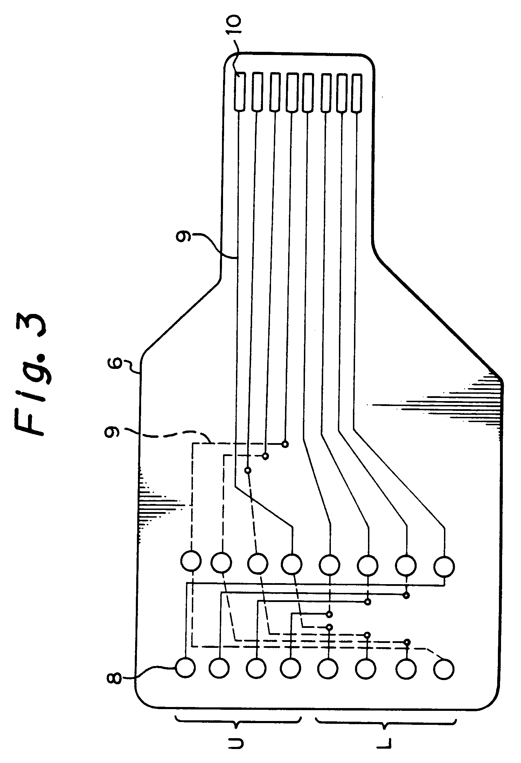

Fig. 3 is a plan view of the flexible cable 6. The flexible cable has the soldered portion 8 at one end portion thereof as set forth above and leads 9 made of copper foil which are provided at the upper and lower surfaces thereof and connected to the soldered portion 8 located at the side of the upper contact position U and the side of the lower contact position L.

The flexible cable further has contact portions 10 provided at the other end portion thereof for connecting the soldered portions 8 located at the side of the upper position U to the corresponding solderd portion 8 located at the side of the lower position L.

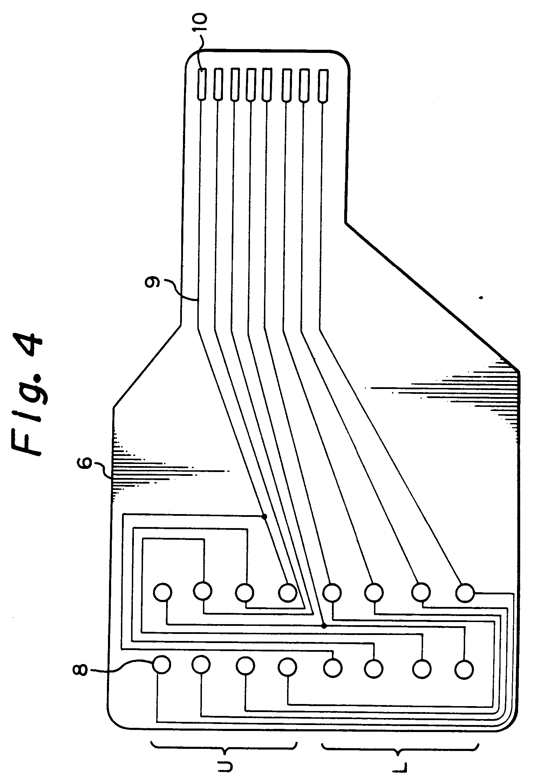

Fig. 4 is a plan view of a flexible cable according to a modification of the present invention. The copper leads 9 are provided at one side surface of the flexible cable 6.

The flexible cable 6 is not limited to those as illustrated in Fig. 3 and 4 but may be those capable of connecting the soldered portions located at the side of the upper position U to the corresponding soldered portions located at the side of the lower position L.

With the arrangement of the IC card connection structure, when the IC card 1 is set at given position, the contact pins 5 of the contact 4 can contact the contact points 1a in either case where the contact points are located at the upper position U or the lower position L.

The signals transmitted from the IC card 1 to the contact 4 by way of the contact points 1a located at the upper position U or the lower position L are supplied to the contact portions 10 by way of the leads 9, then supplied to the control circuit 3.

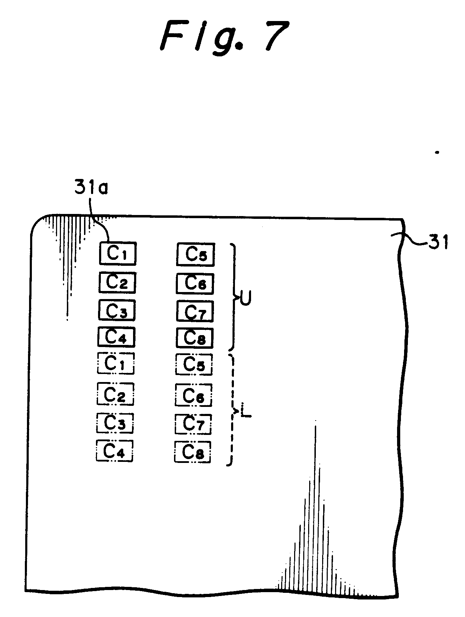

Fig. 7 is a plan view showing an arrangement of contact points 31a of an IC card according to another modification of the present invention. The contact points 31a denoted at same numerals, e.g. the contact point C1 in the upper position U and the contact point C1 in the lower position L have the same signal.

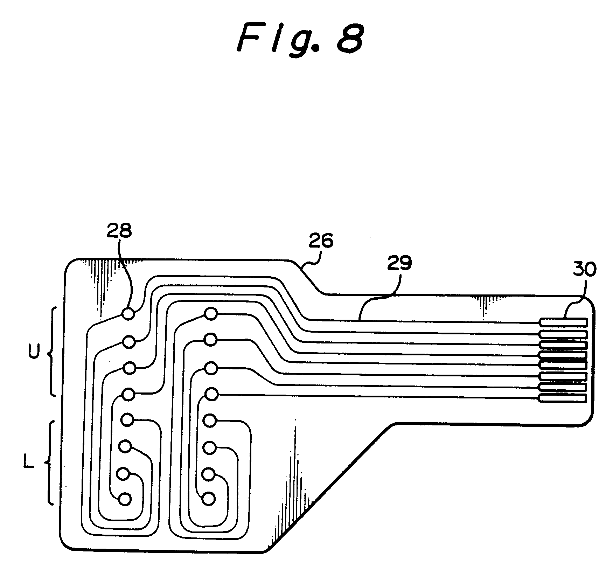

Fig. 8 is a plan view of a flexible cable which is used when the IC card 21 in Fig. 7 is employed.

The flexible cable comprises soldered portions 28 provided at one end thereof which contact pins of a contact are inserted into and connected to, and leads 29 made of copper foil and provided at an upper surface thereof and connected to the soldered portions 28 located at the side of the upper position and the corresponding soldered portions 28 located at the side of the lower position. The flexible cable further comprises contact portions 30 provided at the other end thereof for connecting the soldered portions 28, located at the side of the upper position, and the corresponding soldered portions 28, located at the side of the lower position, for supplying the signals issued from the IC card by way of the contact points in the upper position, or the corresponding contact points in the lower position, to an IC card reader/writer. In this case, the leads 29 are not provided on both surfaces of the flexible cable 26 but on one surface thereof, and it is possible to obviate the need to provide leads 29 between each soldered portion 28 on both sides of the flexible cable.

With the arrangement of the IC card connection structure, it is possible to coneect the IC card to the control circuit of the IC card reader/writer in either case where the IC card has the upper position type or the lower position type.

## Claims

1. An IC card connection structure for connecting an IC card reader or writer to an IC card, including contact points (5) arranged to contact the electrical terminals (la, 31c) of an IC card (1), **characterised in that** said contact points (5) include a first group of contact points disposed for contacting IC card terminals configured in a first manner (U) on the card and a second group of contact points disposed for contacting IC card terminals configured in a second, different manner (L) on the card.

2. A connection structure according to claim 1, wherein there are at least sixteen contact points (5).

3. A connection structure according to claim 1 or 2, wherein the contact points (5) are mounted in a common carrier (4).

4. A connection structure according to claim 3, including a connection member (6,26) at one end of which the common carrier (4) is mounted, wherein the connection member (6,28) is provided with terminals (8,28) for contacting the contact points (5), contact portions (10,30) at an end remote from the terminals (8,28), and conductive paths coupling each contact portion (10,30) to a respective contact point (5) in each said group (U,L).

5. A connection structure according to claim 4, wherein the connection member (6,28) is a flexible cable.

## Patentansprüche

1. Chipkarten-Verbindungsaufbau zur Verbindung eines Chipkartenlesers oder -schreibers mit einer Chipkarte, der Kontaktpunkte (5) enthält, die angeordnet sind, um die elektrischen Anschlüsse (1a, 31c) einer Chipkarte (1) zu berühren, **dadurch gekennzeichnet**, daß die Kontaktpunkte (5) eine erste Gruppe von Kontaktpunkten, die zur Berührung von Chipkartenanschlüssen angeordnet sind, die auf eine erste Weise (U) auf der Karte gruppiert sind, und eine zweite Gruppe von Kontaktpunkten umfassen, die zur Berührung von Chipkartenanschlüssen angeordnet sind, die auf eine zweite, andere Weise (L) auf der Karte gruppiert sind.

2. Verbindungsaufbau nach Anspruch 1, wobei es wenigstens sechzehn Kontaktpunkte (5) gibt.

3. Verbindungsaufbau nach Anspruch 1 oder 2, wobei die Kontaktpunkte (5) in einem gemeinsamen Träger (4) befestigt sind.

4. Verbindungsaufbau nach Anspruch 3, der ein Verbindungselement (6, 26) enthält, an dessen einem Ende der gemeinsame Träger (4) befestigt ist, wobei das Verbindungselement (6, 28) mit Anschlüssen (8, 28) zur Berührung der Kontaktpunkte (5), Kontaktteilen (10, 30) an einem von den Anschlüssen (8, 28) entfernten Ende und Leiterbahnen versehen ist, die jeden Kontaktteil (10, 30) mit einem jeweiligen Kontaktpunkt (5) in jeder Gruppe (U, L) verbinden.

5. Verbindungsaufbau nach Anspruch 4, wobei das Verbindungselement (6, 28) ein flexibles Kabel ist.

## Revendications

1. Structure de connexion de carte à circuit imprimé pour connecter un lecteur ou enregistreur sur carte à circuit imprimé à une carte à circuit imprimé, comprenant des pointes de contact (5) disposées de façon à entrer en contact avec les bornes électriques (1a, 31c) d'une carte (1) à circuit imprimé, caractérisée en ce que lesdites pointes (5) de contact comprennent un premier groupe de pointes de contact disposées pour entrer en contact avec des bornes d'une carte à circuit imprimé configurées d'une première maniyre (U) sur la carte et un second groupe de pointes de contact disposées pour entrer en contact avec des bornes d'une carte à circuit imprimé configurées d'une seconde manière différente (L) sur la carte.

2. Structure de connexion selon la revendication 1, dans laquelle il y a au moins 16 points (5) de contact.

3. Structure de connexion selon la revendication 1 ou 2, dans laquelle les pointes (5) de contact sont montées dans un support commun (4).

4. Structure de connexion selon la revendication 3, comprenant un élément (6, 26) de connexion à une extrémité duquel le support commun (4) est monté, l'élément (6, 28) de connexion étant poourvu de bornes (8, 28) pour entrer en contact avec les pointes (5) de contact, de parties (10, 30) de contact à une extrémité éloignée des bornes (8, 28) et de pistes conductrices couplant chaque partie (10, 30) de contact à une pointe de contact respective (5) dans chacun desdits groupes (U, L).

5. Structure de connexion selon la revendication 4, dans laquelle l'élément (6, 28) de connexion est un câble flexible.
